**Europäisches Patentamt**

**European Patent Office**

**Office européen des brevets**

(19)

(11) Numéro de publication : **0 613 329 A1**

## (12) DEMANDE DE BREVET EUROPEEN

(21) Numéro de dépôt : **94420059.1**

(22) Date de dépôt : **18.02.94**

(51) Int. Cl.⁵ : **H05H 1/46**

(30) Priorité : **25.02.93 FR 9302414**

(43) Date de publication de la demande :
**31.08.94 Bulletin 94/35**

(84) Etats contractants désignés :
**BE CH DE FR GB IT LI NL**

(71) Demandeur : **METAL PROCESS, Société à
Responsabilité Limiteé:
20 Alleé du Château
F-77144 Montevrain (FR)**

(72) Inventeur : **Pelletier, Jacques
Chemin du Fort,
Le Mûrier
F-38400 Saint Martin d'Heres (FR)**
Inventeur : **Durandet, Antoine
10, rue François Ponsard
F-75116 Paris (FR)**

(74) Mandataire : **Thibault, Jean-Marc
Cabinet Beau de Loménie
51, Avenue Jean Jaurès
B.P. 7073
F-69301 Lyon Cédex 07 (FR)**

(54) Dispositif d'excitation d'un plasma à la résonance cyclotronique électronique par l'intermédiaire d'un applicateur filaire d'un champ micro-onde et d'un champ magnétique statique.

(57) - L'invention concerne un dispositif d'excitation d'un plasma comportant au moins un applicateur filaire conducteur électrique (3) alimenté par une source d'énergie dans le domaine des micro-ondes et des moyens (5) de création d'un champ magnétique adaptés pour créer au moins une surface à champ magnétique constant et d'intensité correspondant à la résonance cyclotronique électronique. Selon l'invention, l'applicateur filaire (3) comporte les moyens (5) de création du champ magnétique, dont la composante principale est située dans une section transversale de l'applicateur en s'étendant selon au moins une partie de la longueur de l'applicateur, ce dernier constituant un applicateur à la fois d'un champ électrique micro-onde et d'un champ magnétique statique.

FIG. 2

EP 0 613 329 A1

La présente invention concerne le domaine technique général de la production de plasma à basse pression excité par une énergie micro-onde dans le domaine de la résonance cyclotronique électronique.

La présente invention concerne des applications très diverses, telles que la production de faisceaux d'ions obtenus par extraction du plasma ou les traitements de surface, comme la gravure, le dépôt, le traitement chimique ou thermochimique, la pulvérisation, le nettoyage, la désinfection ou la décontamination.

Dans le domaine de la technique d'excitation d'un plasma à la résonance cyclotronique électronique, la résonance est obtenue lorsque la fréquence de giration d'un électron dans un champ magnétique statique ou quasi statique est égale à la fréquence du champ électrique accélérateur appliqué. Cette résonance est obtenue pour un champ magnétique **B** et une fréquence d'excitation **f** liée par la relation :

$$\mathbf{B} = 2\pi m f/e$$

où **m** et **e** sont la masse et la charge de l'électron.

Dans le cas de l'excitation d'un plasma, la résonance cyclotronique électronique est efficace uniquement si l'électron est suffisamment accéléré, c'est-à-dire si l'électron peut tourner suffisamment longtemps en phase avec le champ électrique pour acquérir l'énergie de seuil nécessaire à l'ionisation du gaz. Pour satisfaire cette condition, il faut, d'une part, que le rayon de giration de l'électron soit suffisamment petit, en particulier, pour rester dans la région de l'espace réunissant les conditions de résonance c'est-à-dire la présence simultanée du champ électrique et du champ magnétique et, d'autre part, que la fréquence de giration **f** reste grande devant la fréquence de collision des électrons sur les éléments neutres, tels que les atomes et/ou les molécules. Autrement dit, les meilleures conditions d'excitation d'un plasma à la résonance cyclotronique électronique sont obtenues à la fois pour une pression de gaz relativement faible et une fréquence **f** de champ électrique élevée, c'est-à-dire aussi pour une intensité de champ magnétique **B** élevée. En pratique, dans un plasma conventionnel, les conditions favorables à une excitation à la résonance cyclotronique électronique sont obtenues pour des fréquences **f** de l'ordre ou supérieures à 500 MHz et des pressions de gaz de l'ordre de 0,1 Pascal ou de $10^{-3}$ à quelques dizaines de Pascals suivant la nature du gaz et la fréquence d'excitation. Toutefois, les fréquences micro-onde supérieures à 10 GHz nécessitent des intensités de champ magnétique très élevées qu'il n'apparaît pas possible d'obtenir avec des aimants permanents actuels et des structures magnétiques simples. A la fréquence **f**, égale à 2,45 GHz, l'intensité **B** vaut 0,0875 Tesla et dépasse 0,35 Tesla à 10 GHz.

Le brevet français n° 85-08 836 décrit une technique d'excitation de plasma à la résonance cyclotronique électronique nécessitant la mise en oeuvre d'aimants permanents créant chacun au moins une surface à champ magnétique constant et d'intensité correspondant à la résonance cyclotronique électronique. L'énergie micro-onde est amenée au niveau de la zone de résonance par l'intermédiaire d'antennes ou d'excitateurs de plasma constitués chacun par un élément filaire métallique. Chaque excitateur s'étend à proximité et le long d'un aimant en étant disposé au droit d'un aimant permanent.

Le champ magnétique d'intensité égale à la valeur donnant la résonance et le champ électrique micro-onde sont tous les deux localisés et confinés essentiellement dans l'espace situé entre un excitateur et la partie de la paroi de l'enceinte placée en regard d'un aimant. En présence d'un milieu gazeux présentant une pression réduite, les électrons sont accélérés dans la zone de résonance et s'enroulent le long des lignes de champ magnétique qui définissent une surface de confinement du plasma. Ces lignes de champ en forme de festons relient le pôle d'un aimant à son pôle opposé ou au pôle opposé d'un aimant consécutif. Le long de son trajet, l'électron dissocie et ionise les molécules et les atomes avec lesquels il entre en collision. Le plasma ainsi formé dans les festons de champ magnétique diffuse ensuite, à partir des lignes de champ, pour former un plasma pratiquement exempt des électrons énergétiques qui restent piégés dans les festons.

L'inconvénient majeur de la technique décrite par ce brevet a trait au fait que la zone de propagation de l'énergie micro-onde et la zone de résonance où l'énergie micro-onde est absorbée, se superposent. La propagation des micro-ondes ne peut donc s'effectuer qu'avec des pertes et l'intensité du champ électrique micro-onde et la densité du plasma diminuent tous deux progressivement le long de la l'excitateur à partir de la source micro-onde. Le plasma obtenu présente une densité non uniforme le long de l'excitateur, de sorte qu'un tel plasma apparaît inadapté à la plupart des applications industrielles.

Pour remédier aux inconvénients énoncés ci-dessus, la demande de brevet français n° 91-00 894 propose de disposer l'applicateur dans une zone inter-aimants comprise entre la paroi de l'enceinte de réaction et les lignes de champ magnétique correspondant à la résonance cyclotronique électronique et reliant deux pôles adjacents de polarités différentes. Cette zone est particulièrement propice à la propagation de l'énergie micro-onde, car elle est pratiquement exempte de plasma. Cet avantage résulte du fait que la diffusion du plasma normalement aux lignes de champ magnétique est considérablement réduite, lorsque l'intensité du champ magnétique statique augmente.

Cette technique présente, toutefois, un inconvénient puisque les zones où le champ électrique micro-onde est maximum et les zones de résonance cyclotronique électronique où l'intensité du champ électrique vaut **B** ne coïncident pas. Pour produire l'excitation du plasma, il convient soit d'accroître l'intensité du champ électrique micro-onde, soit d'augmenter l'intensité du champ magnétique pour étendre la zone de résonance. Si de telles conditions sont respectées, un plasma dense et uniforme peut être produit tout le long de l'excitateur.

En dehors des inconvénients spécifiques aux deux techniques décrites ci-dessus, il convient d'y ajouter des défauts communs relatifs au faible pourcentage de volume utile de champ magnétique produit par les aimants permanents et à la nécessité de placer les antennes dans une position précise par rapport au circuit magnétique. Il convient, également, de noter que la présence des aimants permanents recouvrant les parois externes du réacteur rend difficile le montage de systèmes de refroidissement des parois et les accès à l'enceinte de réaction.

La présente invention vise à remédier aux divers inconvénients énoncés ci-dessus en proposant un dispositif d'excitation d'un plasma visant à obtenir une intensité maximale, à la surface de l'applicateur, du champ magnétique statique et du champ électrique micro-onde, afin d'obtenir un couplage maximum, tout en assurant la propagation et la répartition de l'énergie micro-onde le long de l'applicateur avec un minimum de pertes.

Pour atteindre cet objectif, le dispositif d'excitation d'un plasma comporte au moins un applicateur filaire conducteur électrique alimenté par une source d'énergie dans le domaine des micro-ondes et des moyens de création d'un champ magnétique adaptés pour créer au moins une surface à champ magnétique constant et d'intensité correspondant à la résonance cyclotronique électronique, cette surface s'étendant sur au moins une partie de la longueur de l'applicateur.

Selon l'invention, l'applicateur filaire comporte les moyens de création du champ magnétique, dont la composante principale est située dans une section transversale de l'applicateur en s'étendant selon au moins une partie de la longueur de l'applicateur, ce dernier constituant un applicateur à la fois d'un champ électrique micro-onde et d'un champ magnétique statique.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

La **Fig. 1** représente, de façon schématique en perspective avec arrachement, un dispositif d'excitation d'un plasma conforme à l'invention, placé à l'intérieur d'une enceinte de réaction.

La **Fig. 2** est une vue en perspective illustrant, à plus grande échelle, un dispositif d'excitation conforme à l'invention.

Les **Fig. 3** et **4** représentent, selon une section droite transversale, deux variantes de réalisation du dispositif d'excitation selon l'invention.

Les **Fig. 5** à **7** montrent de façon schématique des arrangements différents des dispositifs d'excitation selon l'invention dans une structure multipolaire.

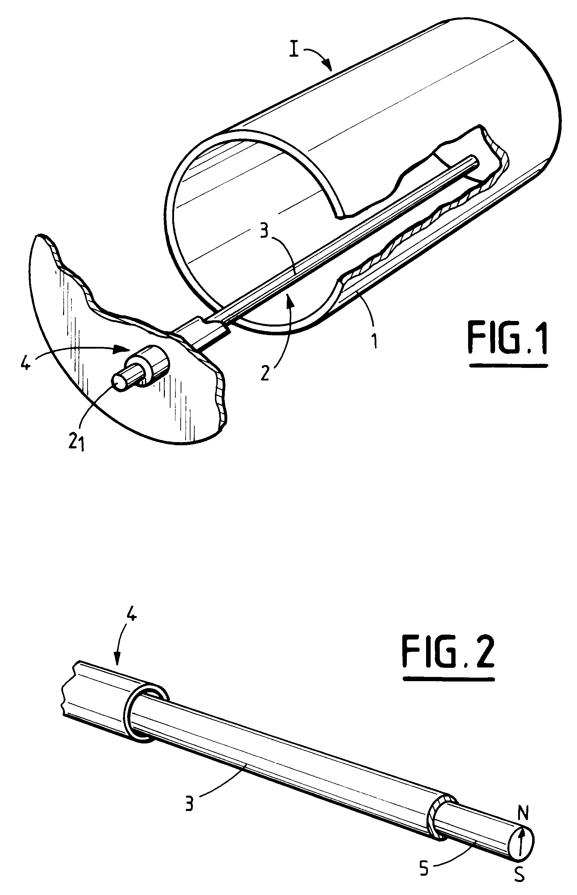

La **Fig. 1** illustre à titre d'exemple un dispositif **I** de production d'un plasma à partir de milieux gazeux de toute nature, en vue d'applications très diverses, telles que les traitements de surface ou la production de faisceaux d'ions. Le dispositif comporte une enceinte étanche **1** équipée classiquement de dispositifs d'introduction de gaz et de pompage de gaz non représentés mais connus en soi permettant de maintenir la pression du gaz à ioniser à une valeur souhaitée qui peut être, par exemple, de l'ordre de $10^{-3}$ à quelques dizaines de Pascals suivant la nature du gaz et la fréquence d'excitation. Le dispositif de production **I** comporte, également, un dispositif **2** conforme à l'invention assurant l'excitation du plasma à la résonance cyclotronique électronique.

Le dispositif d'excitation **2** selon l'invention comporte au moins un applicateur **3** réalisé en un matériau assurant une bonne conduction de l'énergie électrique, comme par exemple en métal. L'applicateur **3** présente une forme filaire, c'est-à-dire allongée. L'applicateur filaire **3** est raccordé à l'une de ses extrémités par tous moyens appropriés, tels qu'une structure coaxiale à une source d'énergie dans le domaine des micro-ondes. Dans l'exemple illustré aux **Fig. 1** et **2**, l'applicateur filaire **3** prolonge l'âme centrale $2_1$ d'un câble coaxial **4**. D'une manière plus générale, une même structure coaxiale peut aussi alimenter deux applicateurs opposés ou plusieurs applicateurs disposés en étoile.

Le dispositif d'excitation **2** comporte, également, des moyens **5** de création d'un champ magnétique adaptés pour créer, sur au moins une partie de la longueur de l'applicateur **3**, au moins une surface à champ magnétique constant et d'intensité correspondant à la résonance cyclotronique électronique. Selon l'invention, l'applicateur filaire **3** comporte les moyens **5** de création d'un champ magnétique statique, de manière que l'applicateur **3** assure localement l'application à la fois d'un champ électrique micro-onde et d'un champ magnétique statique. Les moyens **5** de création d'un champ magnétique font ainsi partie intégrante ou se trouvent incorporés directement à l'applicateur filaire **3**. Les moyens **5** créent un champ magnétique statique nécessaire à l'obtention des conditions de résonance sur au moins une partie et, notamment, sur la totalité de la longueur de l'applicateur.

Les moyens **5** sont prévus pour créer un champ magnétique ayant un caractère uniforme tout le long de l'applicateur, afin d'éviter, en présence du plasma, des ruptures d'impédance trop nombreuses pour les micro-ondes. La composante principale du champ magnétique se trouve donc ainsi située dans une section transversale de l'applicateur sur la partie ou la totalité de la longueur de l'applicateur définie par la zone d'application du champ magnétique. Dans la mesure où la composante principale du champ magnétique reste dans une section transversale de l'applicateur, il en découle nécessairement un champ magnétique de caractère uniforme le long de l'applicateur.

Selon l'invention, le champ magnétique statique et le champ électrique micro-onde sont tous les deux d'intensité maximale à la surface de l'applicateur. Le champ électrique micro-onde se propage entre l'applicateur et le plan de masse le plus proche, c'est-à-dire la paroi de l'enceinte **1** ou le plasma lorsque celui-ci est excité. La propagation de l'onde le long de l'applicateur s'effectue favorablement dans les zones de champ magnétique proches de l'applicateur exemptes de plasma et en dehors de la zone de résonance cyclotronique électronique. Un tel dispositif permet de localiser la puissance micro-onde dans l'environnement proche de l'applicateur offrant l'avantage d'éviter une répartition des micro-ondes dans tout le volume de l'enceinte **1**.

Selon une forme de réalisation, les moyens **5** peuvent être réalisés par l'intermédiaire d'un courant électrique continu parcourant l'applicateur filaire **3** et dont l'intensité est choisie pour créer le champ magnétique statique nécessaire à l'obtention des conditions de résonance le long de l'applicateur. Ce courant électrique peut parcourir l'applicateur filaire lui-même ou un conducteur ou supraconducteur monté à l'intérieur de l'applicateur. Dans cet exemple, il est à noter que la composante du champ magnétique se situe dans la section transversale droite de l'applicateur.

Selon une version préférée de réalisation, les moyens de création du champ magnétique **5** sont constitués par au moins un aimant permanent. Dans la variante de réalisation illustrée plus particulièrement à la **Fig. 2**, l'applicateur filaire **3** est formé par un tube à l'intérieur duquel est monté, avec un jeu ou non, un aimant cylindrique aimanté perpendiculairement à son axe et présentant ainsi un pôle nord et un pôle sud diamétralement opposés. Bien entendu, il peut être envisagé d'incorporer à l'applicateur **3** une pluralité d'aimants permanents de sections diverses, par exemple hexagonale, carrée ou rectangulaire. Dans le même sens, l'applicateur **3** peut présenter une section transversale droite de forme quelconque. Par ailleurs, l'applicateur filaire **3** peut être réalisé à partir d'un dépôt métallique de faible résistivité destiné à revêtir la surface extérieure de l'aimant. Dans le cas où les moyens **5** sont constitués par un aimant, il est à considérer que les aimants sont montés à l'intérieur de l'applicateur, de telle manière que la composante principale du champ magnétique se situe, de préférence, dans la section transversale droite de l'applicateur mais peut se situer, également, dans une section transversale décalée angulairement par rapport à la section transversale droite.

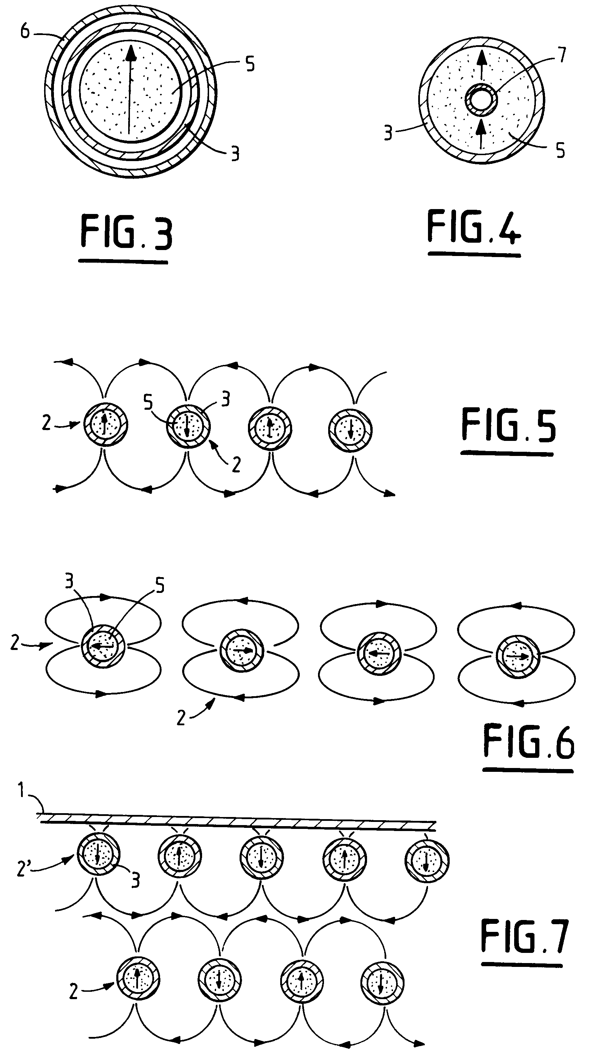

Tel que cela apparaît plus précisément à la **Fig. 3**, il peut être avantageux d'entourer l'applicateur **3** par l'intermédiaire d'une enveloppe diélectrique **6** en vue d'obtenir une isolation électrique ou thermique du dispositif vis-à-vis de l'extérieur ou pour éviter des risques de contamination métallique, voire pour mieux assurer la propagation sans perte de l'énergie micro-onde le long de l'applicateur en présence de plasma. L'enveloppe diélectrique **6** peut se présenter sous la forme d'une couche diélectrique déposée directement sur l'applicateur filaire, c'est-à-dire sur le tube **3**, ou sur le dépôt métallique recouvrant l'aimant. Comme illustré à la **Fig. 3**, l'enveloppe diélectrique **6** peut être aussi réalisée par un tube entourant, à distance ou non, l'applicateur filaire **3**.

La **Fig. 4** illustre un dispositif d'excitation conforme à l'invention comportant au moins une canalisation **7** de circulation d'un fluide de refroidissement de l'applicateur **3**. La canalisation de refroidissement **7** est disposée, soit entre l'aimant **5** et l'applicateur **3**, soit à l'intérieur de l'aimant, comme illustré sur le dessin. Dans le cas de la mise en oeuvre de canalisations aller et retour, il peut être prévu que l'une des canalisations se trouve montée à l'intérieur de l'aimant, tandis que l'autre canalisation est placée entre l'aimant et l'applicateur.

L'applicateur filaire selon l'invention constitue ainsi un dispositif d'excitation autonome pouvant être utilisé dans des applications nécessitant un applicateur unique. D'une manière plus générale, il peut être prévu d'utiliser ce type d'applicateur en association, par exemple, dans une structure de type multipolaire. Il peut ainsi être envisagé de réaliser des sources de plasma du type multipolaire à résonance cyclotronique électronique de géométries, de dimensions et de formes très variées en fonction du nombre et de la disposition des applicateurs autonomes. Dans les exemples illustrés aux **Fig. 5** à **7**, les applicateurs sont disposés pour définir une configuration multipolaire de nature plane. A titre d'exemple, les aimants **5** associés aux applicateurs **3** peuvent être, soit disposés de manière que leur polarité se trouve alternativement de sens opposé afin d'assurer la fermeture du champ magnétique d'un dispositif à l'autre (**Fig. 5** et **6**) ou soit orientés d'une manière quelconque, de sorte que le champ magnétique est indépendant pour chaque dispositif. Selon certaines applications, il peut être envisagé d'alimenter en énergie micro-onde, par exemple un applicateur sur deux ou de disposer d'applicateurs **3** dépourvus chacun des moyens **5** de création du champ magnétique statique mais alimentés en énergie micro-onde.

Les structures multipolaires illustrées aux **Fig. 5, 6** permettent la production d'un plasma de part et d'autre du plan contenant les applicateurs. Dans diverses applications, il peut être prévu d'utiliser une deuxième série de dispositifs d'excitation **2'** conformes à l'invention pour assurer le confinement du plasma. Comme illustré à la **Fig. 7**, les dispositifs d'excitation **2'** appartenant à cette seconde série comportent des applicateurs filaires **3** qui ne sont pas alimentés en énergie micro-onde. Une telle structure permet d'assurer le confinement du plasma d'un seul côté des dispositifs d'excitation **2**, qui est celui qui ne comporte pas les dispositifs de confinement. Bien entendu, les applicateurs **2'** peuvent être montés à l'intérieur ou à l'extérieur de la paroi de l'enceinte **1**.

D'une manière générale, d'autres structures multipolaires sont à envisager sans sortir du cadre de l'invention et mettant en oeuvre des applicateurs filaires non alimentés en énergie micro-onde et dépourvus des moyens de création de champ magnétique statique. De tels applicateurs, reliés par exemple à la masse, améliorent la propagation et le confinement des micro-ondes à proximité des applicateurs du champ électrique et magnétique. Il est à noter que de tels applicateurs ou tubes peuvent aussi assurer la distribution de gaz, de photons, d'électrons additionnels, de rayonnements, etc.

L'invention permet ainsi de remédier aux problèmes de l'application dissociée du champ électrique micro-onde et du champ magnétique statique. Selon l'invention, l'applicateur filaire est autonome, ce qui autorise une souplesse d'utilisation, en particulier pour le choix des configurations d'enceinte de réaction et des domaines d'application.

Un autre avantage est l'efficacité du dispositif puisque le champ électrique micro-onde et le champ magnétique statique sont localisés le long de l'applicateur filaire et sont tous les deux maximum à la surface de l'applicateur. L'intégration à l'applicateur des moyens de création du champ magnétique pour former un seul élément permet, en outre, une simplicité accrue de mise en oeuvre y compris sur des enceintes de réacteurs existants. Enfin, la possibilité d'utiliser ces applicateurs comme paroi virtuelle du plasma permet de réduire considérablement les contaminations dues aux interactions plasma/parois.

L'invention n'est pas limitée aux exemples décrits et représentés, car diverses modifications peuvent y être apportées sans sortir de son cadre.

## Revendications

**1 -** Dispositif d'excitation d'un plasma du type comportant :

- au moins un applicateur filaire conducteur électrique **(3)** alimenté par une source d'énergie dans le domaine des micro-ondes,
- et des moyens **(5)** de création d'un champ magnétique adaptés pour créer au moins une surface à champ magnétique constant et d'intensité correspondant à la résonance cyclotronique électronique, cette surface s'étendant sur au moins une partie de la longueur de l'applicateur,

caractérisé en ce que l'applicateur filaire **(3)** comporte les moyens **(5)** de création du champ magnétique, dont la composante principale est située dans une section transversale de l'applicateur en s'étendant selon au moins une partie de la longueur de l'applicateur, ce dernier constituant un applicateur à la fois d'un champ électrique micro-onde et d'un champ magnétique statique.

**2 -** Dispositif selon la revendication 1, caractérisé en ce que l'applicateur filaire **(3)** est parcouru par un courant électrique continu qui constitue les moyens **(5)** de création du champ magnétique.

**3 -** Dispositif selon la revendication 1, caractérisé en ce que l'applicateur filaire **(3)** comporte au moins un aimant permanent qui constitue les moyens **(5)** de création du champ magnétique.

**4 -** Dispositif selon la revendication 3, caractérisé en ce que les moyens de création du champ magnétique **(5)** sont constitués par au moins un aimant permanent monté à l'intérieur de l'applicateur **(3)** formé par un tube.

**5 -** Dispositif selon l'une des revendications 2 à 4, caractérisé en ce que l'applicateur **(3)** est entouré par une enveloppe diélectrique **(6)**.

**6 -** Dispositif selon l'une des revendications 1 à 3, caractérisé en ce que l'applicateur **(3)** comporte au moins une canalisation **(7)** de circulation d'un fluide de refroidissement.

**7 -** Dispositif selon la revendication 6, caractérisé en ce que la canalisation de circulation d'un fluide de refroidissement **(7)** est ménagée à l'intérieur de l'aimant permanent **(5)** et/ou entre l'aimant permanent **(5)** et le tube **(3)** formant l'applicateur.

**8 -** Structure de production d'un plasma comprenant une enceinte étanche **(1)** raccordée à un circuit de pompage et à un circuit d'apport d'un milieu gazeux pour maintenir une pression déterminée dans l'enceinte, caractérisée en ce qu'elle comporte une série de dispositifs d'excitation d'un plasma conformes à l'une des revendications 1 à 7, et disposés côte à côte.

**9 -** Structure selon la revendication 8, caractérisée en ce que certains des applicateurs **(3)** des dispositifs sont alimentés en énergie dans le domaine des micro-ondes.

**10 -** Structure selon la revendication 8 ou 9, caractérisée en ce que certains des applicateurs **(3)** des dispositifs sont dépourvus des moyens **(5)** de création du champ magnétique.

**11 -** Structure selon la revendication 8, 9 ou 10, caractérisée en ce que certains des applicateurs **(3)** des dispositifs ne sont pas alimentés en énergie micro-onde et sont dépourvus des moyens de création du champ magnétique statique.

**12 -** Structure selon l'une des revendications 8 à 11, caractérisée en ce qu'elle comporte au moins des moyens de confinement du plasma formés par une série de dispositifs d'excitation **(2')** conformes à l'une des revendications 1 à 7, et dont les applicateurs **(3)** ne sont pas alimentés en énergie dans le domaine des micro-ondes.

I

3

2

4

21

1

FIG.1

4

FIG.2

3

5

N

S

FIG.3

FIG.4

FIG.5

FIG.6

FIG.7

EP 0 613 329 A1

**Office européen des brevets**

# RAPPORT DE RECHERCHE EUROPEENNE

Numero de la demande

EP 94 42 0059

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| D,A | EP-A-0 496 681 (METAL PROCESS)<br><br>* colonne 2, ligne 20 - ligne 49 *<br>* colonne 3, ligne 14 - ligne 27 *<br>* colonne 4, ligne 3 - ligne 10 *<br>* colonne 5, ligne 2 - ligne 29 *<br>* figures 1-2 *<br>--- | 1,5,6,<br>8-12 | H05H1/46 |
| A | EP-A-0 391 156 (MICHIGAN STATE UNIV.)<br>* colonne 7, ligne 14 - ligne 20 *<br>* colonne 9, ligne 53 - colonne 10, ligne 33 *<br>* figures 1,6 *<br>--- | 3-4 | |
| A | PATENT ABSTRACTS OF JAPAN<br>vol. 10, no. 192 (E-417) (2248) 5 Juillet 1986<br>& JP-A-61 039 521 (ANELVA CO.) 25 Février 1986<br>* abrégé *<br>--- | 4 | |
| A | EP-A-0 109 808 (ENERGY CONVERSION DEVICES)<br>* page 14, dernier alinéa - page 15, alinéa 1 *<br>* figure 5 *<br>--- | 1,5 | **DOMAINES TECHNIQUES RECHERCHES (Int.Cl.5)**<br><br>H05H<br>H01J |
| A | EP-A-0 411 317 (CANON)<br>* page 27, ligne 7 - ligne 14 *<br>* figure 5 *<br>--- | 6 | |
| A | EP-A-0 402 282 (CNRS ET CNET)<br>* colonne 5, ligne 32 - colonne 6, ligne 53 *<br>* figure 1 *<br>---<br>-/-- | 8-9 | |

Le présent rapport a été établi pour toutes les revendications

| Lieu de la recherche | Date d'achèvement de la recherche | Examinateur |
|---|---|---|
| LA HAYE | 16 Mai 1994 | Capostagno, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

9

**Office européen des brevets**

# RAPPORT DE RECHERCHE EUROPEENNE

Numero de la demande

EP 94 42 0059

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| D,A | FR-A-2 583 250 (CNRS ET CNET)<br>* page 4, ligne 13 - page 5, ligne 10 *<br>* page 6, ligne 35 - page 7, ligne 21 *<br>* page 8, ligne 1 - ligne 5 *<br>* page 8, ligne 35 - page 9, ligne 10 *<br>* figures 1,4-5 *<br>----- | 1,6,8 | |

**DOMAINES TECHNIQUES RECHERCHES (Int.Cl.5)**

Le présent rapport a été établi pour toutes les revendications

| Lieu de la recherche | Date d'achèvement de la recherche | Examinateur |
|---|---|---|
| LA HAYE | 16 Mai 1994 | Capostagno, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)